# EUROPÄISCHE PATENTSCHRIFT

(11) **EP 1 379 005 B1**
(45) Veröffentlichungstag und Bekanntmachung des Hinweises auf die Patenterteilung: **08.06.2011**
(21) Anmeldenummer: 03005899.4
(22) Anmeldetag: 17.03.2003
(51) Int. Cl.: H04B 1/16

(54) **Verfahren und Schaltungsanordnung zum Beeinflussen der Höhenwiedergabe eines Audiosignals**
Method and circuit arrangement for influencing the reproduction of high frequencies of an audio signal
Procédé et agencement de circuit pour influencer la reproduction des hautes fréquences d'un signal audio

(30) Priorität: 04.06.2002 DE 10224699
(43) Veröffentlichungstag der Anmeldung: 07.01.2004
(73) Patentinhaber: ROBERT BOSCH GMBH, 70442 Stuttgart (DE)
(72) Erfinder: Risse, Marcus, 31137 Hildesheim (DE)

(56) Entgegenhaltungen:
- WO-A-98/38835
- JP-A- 8 293 750
- JP-A- 9 018 989
- JP-A- 2001 175 292
- US-A- 5 661 810

## Beschreibung

### Technisches Gebiet

Die vorliegende Erfindung betrifft ein Verfahren zum Beeinflussen, insbesondere zum Verringern, der Höhenwiedergabe eines wiederzugebenden, aus einem empfangenen Signal gewonnenen Audiosignals, wobei die Empfangsfeldstärke sowie die Empfangsqualität des empfangenen Signals ausgewertet werden und in Abhängigkeit hiervon die Übertragungsfunktion mindestens einer mit dem Audiosignal beaufschlagbaren Filtereinheit gesteuert wird.

Die vorliegende Erfindung betrifft des weiteren eine Schaltungsanordnung zum Beeinflussen, insbesondere zum Verringern, der Höhenwiedergabe eines wiederzugebenden, aus einem empfangenen Signal gewonnenen Audiosignals, wobei die Empfangsfeldstärke sowie die Empfangsqualität des empfangenen Signals auswertbar sind und in Abhängigkeit hiervon die Übertragungsfunktion mindestens einer mit dem Audiosignal beaufschlagbaren Filtereinheit steuerbar ist.

### Stand der Technik

In gestörten Empfangsgebieten sind bei Empfang eines f[requenz]m[odulierten] Senders insbesondere durch Mehrwegeausbreitung bedingte Störungen deutlich wahrnehmbar. Eine geringere Wahrnehmung derartiger Störungen kann durch Verringern der Höhenwiedergabe erzielt werden.

In konventionellen Systemen erfolgt die Steuerung dieses Verringerns der Höhenwiedergabe in der Regel durch Auswerten der Empfangsfeldstärke und/oder der Empfangsqualität; proportional hierzu wird die Übertragungsfunktion eines Filters im Audio-Signalzweig gesteuert. Die Höhen werden hierbei in der Regel schnell zurückgenommen und auch schnell wieder zugeschaltet.

In diesem Zusammenhang erweist sich das schnelle Zurücknehmen und wieder Zuschalten der Höhen jedoch insofern als nachteilig, als die Wiedergabe der Störungen hierdurch nicht immer und nicht zuverlässig kaschiert werden kann, wobei unter anderem auffällige und lästige "Flattereffekte" auftreten; des weiteren ist es mit den konventionellen Verfahren und Schaltungsanordnungen nicht möglich, die Modifikation der Höhenwiedergabe mit einer Reduzierung der Kanaltrennung abzustimmen.

Bekannt ist bereits ein Verfahren zur Beeinflussung der Stereo-Kanaltrennung eines wiederzugebenden aus einem empfangenden Rundfunksignal gewonnenen Audiosignals in einem Rundfunkempfänger, bei dem ein aus der Empfangsfeldstärke des empfangenen Rundfunksignals abgeleitetes Feldstärke-Hilfssignal und ein aus Empfangsstörungen anzeigenden Signalen abgeleitetes Stör-Hilfssignal miteinander und mit einem Knalatrennungs-Hilfssignal, das aus einem die Störhäufigkeit anzeigenden Signal abgeleitet ist, zur Bildung eines die Stereo-Kanaltrennung beeinflussenden Faktors D verknüpft werden (WO 98/38835).

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, ein Verfahren der eingangs genannten Art sowie ein System der eingangs genannten Art in bezug auf die Änderung der Höhenwiedergabe so weiterzubilden, daß die Wiedergabe der Störungen stets zuverlässig kaschiert wird und daß keine auffälligen und/oder lästigen "Flattereffekte" auftreten. In diesem Zusammenhang zielt die vorliegende Erfindung des weiteren darauf ab, die Modifikation der Höhenwiedergabe mit einer Reduzierung der Kanaltrennung abzustimmen.

Diese Aufgabe wird durch ein Verfahren mit den im Anspruch 1 angegebenen Merkmalen sowie durch eine Schaltungsanordnung mit den im Anspruch 6 angegebenen Merkmalen gelöst. Vorteilhafte Ausgestaltungen und zweckmäßige Weiterbildungen der vorliegenden Erfindung sind in den jeweiligen Unteransprüchen gekennzeichnet.

Gemäß der Lehre der vorliegenden Erfindung weist mithin die Steuerung einen mit langsamer Verarbeitungsgeschwindigkeit arbeitenden Teil (= erster Verarbeitungszweig = sogenannte erste "HiCut-Stufe") und einen mit höherer Verarbeitungsgeschwindigkeit arbeitenden Teil (= zweiter Verarbeitungszweig = sogenannte zweite "HiCut-Stufe") auf.

Der technische Sinn dieser Aufteilung gemäß der vorliegenden Erfindung ist darin zu sehen, daß in einem stark gestörten Empfangsgebiet die Höhenwiedergabe für eine längere Zeit - von bis zu etwa dreißig Sekunden - bedämpft werden soll (sogenanntes "HiCut"). Das Schalten der unterschiedlichen HiCut-Stufen hat hierbei langsam zu erfolgen, damit das Schalten nicht wahrnehmbar ist; diese Funktion wird durch die Steuerung mit langsamer Verarbeitungsgeschwindigkeit, das heißt durch den ersten Verarbeitungszweig realisiert.

Bei sporadisch auftretenden Störungen ist hingegen ein längeres Zurücknehmen der Höhenwiedergabe auffälliger als die Störung selbst. In diesem Falle werden die Höhen nur kurz zurückgenommen und auch schnell wieder zugeschaltet; diese Funktion wird durch die Steuerung mit schneller Verarbeitungsgeschwindigkeit, das heißt durch den zweiten Verarbeitungszweig realisiert. Wird die Höhenwiedergabe schnell und häufig reduziert, wird dieses Vorgehen allerdings zu auffällig.

Im Übergangsbereich zwischen häufigen Störungen und sporadischen Störungen erfolgt eine Kombination aus langsamer Steuerung und aus schneller Steuerung; in diesem Falle erfolgt in erfindungswesentlicher Weise eine Höhenabsenkung mit langsamer Zeitkonstante und additiv eine kurzzeitige schnelle Höhenabsenkung mit geringer Dynamik nur beim Auftreten der Störung.

Gemäß einer besonders vorteilhaften Weiterbildung der vorliegenden Erfindung bedeutet dies, daß die mittels der langsamen Steuerung und/oder mittels der schnellen Steuerung bewerkstelligte Höhenabsenkung (= Verringern der Höhenwiedergabe des wiederzugebenden Audiosignals) durch eine Maximalwertbildung überlagert wird.

Bei nur sporadisch oder vereinzelt auftretenden Störungen wird die Höhenabsenkung durch die langsame Steuerung klein, unter Umständen verschwindet die Höhenabsenkung sogar, das heißt ist gar nicht vorhanden; in diesem Falle wirkt nur die für kurze Zeit ansprechende schnelle Steuerung.

Bei Störungen mit mittlerer Häufigkeit wird sich die Höhenabsenkung der langsamen Steuerung auf einen mittleren Wert einstellen; in diesem Falle ergibt sich während des Ansprechens der schnellen Steuerung eine größere Höhenabsenkung.

Bei häufigen Störungen (= hohe Störhäufigkeit) gibt es zwei Möglichkeiten: Ist die Dynamik der langsamen Steuerung und der schnellen Steuerung gleich, so ergibt sich nach der Maximalwertbildung das Signal der langsamen Steuerung; ist hingegen die Dynamik der langsamen Steuerung geringer als die Dynamik der schnellen Steuerung, so werden auch bei häufig auftretenden Störungen kurze Absenkungen um die Differenz der Dynamik der beiden Steuerungen addiert.

Wenn das vorliegende Verfahren sowie die vorliegende Schaltungsanordnung in besonders erfinderischer Weise weitergebildet werden sollen, so kann der erste Verarbeitungszweig mit einer ersten Abtastrate in der Größenordnung von 0 Hertz bis etwa 950 Hertz arbeiten, so daß die Höhenwiedergabe mittels des ersten Verarbeitungszweigs für Zeiträume von bis zu etwa dreißig Sekunden bedämpft werden kann.

Unabhängig hiervon oder in Verbindung hiermit kann der zweite Verarbeitungszweig mit einer zweiten Abtastrate in der Größenordnung von etwa 9,5 Kilohertz arbeiten, denn für eine nahezu verzögerungsfreie Reaktion auf Empfangsstörungen sollte diese zweite Abtastrate so hoch wie möglich gewählt werden; auf diese Weise kann die Höhenwiedergabe mittels des zweiten Verarbeitungszweigs für Zeiträume von wesentlich kürzer als dreißig Sekunden bedämpft werden.

In bezug auf die vorliegende Erfindung ist ein weiterer Vorzug darin zu sehen, daß sowohl mit dem Verfahren als auch mit der Schaltungsanordnung ein konventionellerweise bislang unbekannter Weg zur Absenkung der Störungswahrnehmung im gestörten Empfangsgebiet beschritten wird; auf diesem Weg wird bei gestörtem Empfang nicht nur die Höhenwiedergabe gedämpft, sondern gleichzeitig auch die Stereo-Kanaltrennung reduziert.

Die beiden Steuerungen (Beeinflussung, nämlich Dämpfung der Höhenwiedergabe und Reduzierung der Stereo-Kanaltrennung) werden hierbei in erfindungswesentlicher Weise so aneinandergekoppelt, daß für den langsamen Teil (= erster Verarbeitungszweig) der HiCut-Steuerung und für den langsamen Teil der Steuerung der Kanaltrennung dieselben Detektoren und Schwellentscheide eingesetzt werden; hierdurch ist ein Auseinanderlaufen dieser beiden Steuerungen ausgeschlossen.

Die vorliegende Erfindung betrifft schließlich die Verwendung eines Verfahrens gemäß der vorstehend dargelegten Art und/oder mindestens einer Schaltungsanordnung gemäß der vorstehend dargelegten Art zum Beeinflussen, insbesondere zum Verringern, der Höhenwiedergabe eines wiederzugebenden, aus einem empfangenen Rundfunksignal gewonnenen Audiosignals in mindestens einem Rundfunkempfänger, insbesondere in mindestens einem Rundfunkempfänger mit digitaler Z[wischen]F[requenz]-Verarbeitung, wie etwa in mindestens einem sogenannten "DigiCeiver" (= digital receiver = digitale Empfangseinheit) oder "Digital Car Radio", zum Beispiel der Firma Blaupunkt.

### Kurze Beschreibung der Zeichnungen

Weitere Ausgestaltungen, Merkmale und Vorteile der vorliegenden Erfindung werden nachstehend anhand des durch die Figuren 1 bis 7L veranschaulichten Ausführungsbeispiels näher erläutert.

Es zeigt:
- Fig. 1: ein schematisches Blockschaltbild eines Ausführungsbeispiels einer Schaltungsanordnung gemäß der vorliegenden Erfindung;
- Fig. 2A: ein schematisches Diagramm eines ersten bzw. zweiten Schwellwertentscheids im ersten Verarbeitungszweig der Schaltungsanordnung aus Fig. 1;
- Fig. 2B: ein schematisches Diagramm, in dem die dritten Schwellwerte im ersten Verarbeitungszweig der Schaltungsanordnung aus Fig. 1 in Relation zu den Zeigern im ersten Verarbeitungszweig der Schaltungsanordnung aus Fig. 1 gesetzt sind;
- Fig. 3: ein schematisches Diagramm einer asymmetrischen Rampe mit kurzer Anstiegszeit und mit langer Abfallzeit;
- Fig. 4A: ein schematisches Diagramm einer Kennlinie in einer ersten Ausgestaltungsform;
- Fig. 4B: ein schematisches Diagramm einer Kennlinie in einer zweiten Ausgestaltungsform;
- Fig. 5A: ein schematisches Diagramm eines vierten bzw. fünften Schwellwertentscheids im zweiten Verarbeitungszweig der Schaltungsanordnung aus Fig. 1;
- Fig. 5B: ein schematisches Diagramm, in dem die sechsten Schwellwerte im zweiten Verarbeitungszweig der Schaltungsanordnung aus Fig. 1 in Relation zu den Zeigern im zweiten Verarbeitungszweig der Schaltungsanordnung aus Fig. 1 gesetzt sind;
- Fig. 6: ein schematisches Diagramm der Einstellung der acht zur Verfügung stehenden Filterkurven ("HiCut"); und
- Fig. 7A: bis 7L eine schematische Gegenüberstellung der prinzipiellen Funktionsweise der vorliegenden Erfindung bei geringer Störhäufigkeit (Fig. 7A, 7B, 7C, 7D), bei mittlerer Störhäufigkeit (Fig. 7E, 7F, 7G, 7H) und bei hoher Störhäufigkeit (Fig. 7I, 7J, 7K, 7L).

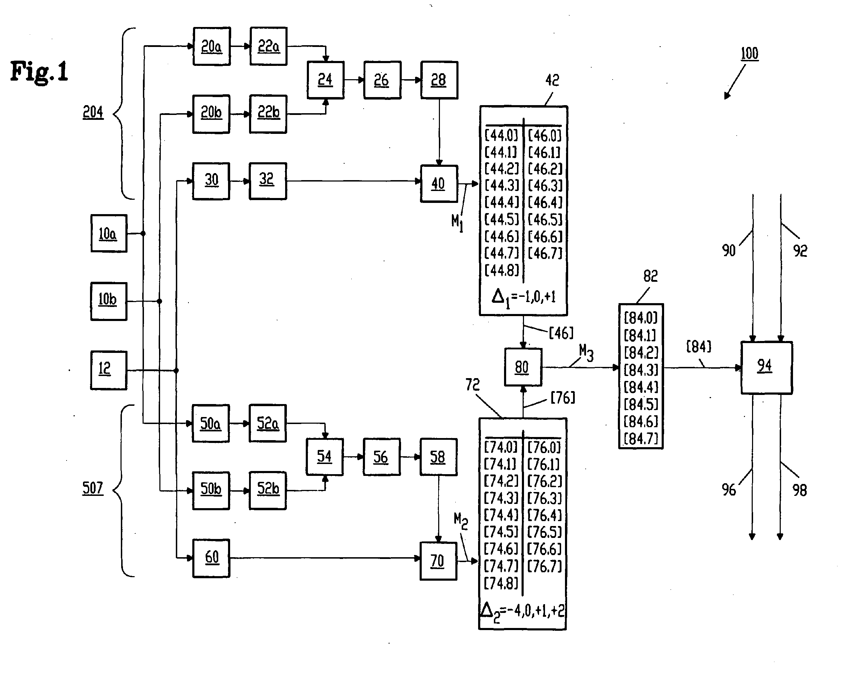

Gleiche oder ähnliche Ausgestaltungen, Elemente oder Merkmale sind in den Figuren 1 bis 7L mit identischen Bezugszeichen versehen.

### Bester Weg zur Ausführung der Erfindung

Beim anhand der Figuren 1 bis 7L veranschaulichten Ausführungsbeispiel der vorliegenden Erfindung handelt es sich um eine Schaltungsanordnung 100, mit der ein Verfahren zum Beeinflussen, nämlich zum Verringern, der Höhenwiedergabe eines wiederzugebenden, aus einem empfangenen f[requenz]m[odulierten] Rundfunksignal gewonnenen Audiosignals (linker Stereokanal 90, rechter Stereokanal 92; vgl. Figur 1) durchgeführt werden kann. Die Audiosignale werden hierbei von in den Figuren 1 bis 7L und speziell in Figur 1 aus Gründen der Übersichtlichkeit der Darstellung nicht explizit gezeigter externer Quelle bereitgestellt oder geliefert, und zwar insbesondere für Radioprogramme, im speziellen auch für Nachrichten und für Verkehrsmeldungen.

Das Verfahren gemäß dem Ausführungsbeispiel der vorliegenden Erfindung basiert im wesentlichen darauf, daß die Empfangsfeldstärke 12 sowie die Empfangsqualität des empfangenen Rundfunksignals ausgewertet werden und proportional hierzu die Übertragungsfunktion einer mit dem Audiosignal 90, 92 beaufschlagbaren Filtereinheit 94 gesteuert wird, so daß aus der Filtereinheit 94 ein gefiltertes Audiosignal (L[inks]-Kanal 96 des Stereokanals; R[echts]-Kanal 98 des Stereokanals) herauskommt, bei dem die durch Mehrwegeausbreitung bedingten Störungen weniger wahrnehmbar oder sogar so gut wie nicht mehr wahrnehmbar sind.

Eine Besonderheit der Schaltungsanordnung 100 besteht nun darin, daß die Signalverarbeitung in zwei voneinander baulich und funktionell getrennten Verarbeitungszweigen 204 und 507 erfolgt, das heißt die Schaltungsanordnung 100 weist hinter zwei vorgeschalteten Empfangsstörungsdetektoren, nämlich hinter einem Hochpaßdetektor 10a und hinter einem 19 Kilohertz-A[mplituden]M[odulations]-Detektor 10b einen ersten Verarbeitungszweig 204, der mit einer ersten variablen Abtastrate arbeitet, und einen zweiten Verarbeitungszweig 507 auf, der mit einer zweiten Abtastrate arbeitet, die von der ersten Abtastrate verschieden, nämlich höher als die erste Abtastrate ist.

Diese unterschiedliche Einstellung der beiden Abtastraten bewirkt nun, daß die Ausgangssignale der beiden Empfangsstörungsdetektoren 10a, 10b sowie das Signal der Empfangsfeldstärke 12 jeweils so verarbeitet werden, daß die Höhenwiedergabe mittels des ersten Verarbeitungszweigs 204 für längere Zeiträume als mittels des zweiten Verarbeitungszweigs 507 bedämpft werden kann.

Im folgenden soll zunächst die in der oberen Hälfte von Figur 1 dargestellte Steuerung mit langsamer Verarbeitungsgeschwindigkeit, das heißt der für längere Zeiträume vorgesehene erste Verarbeitungszweig 204 betrachtet werden. Bei dieser "langsamen Steuerung" ist die Abtastrate zwischen 0 Hertz und 950 Hertz einstellbar.

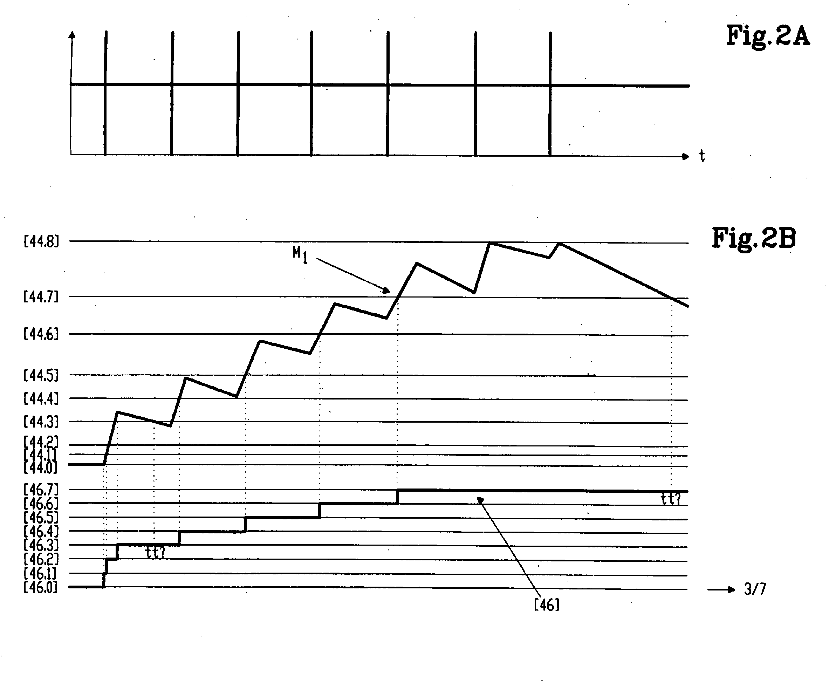

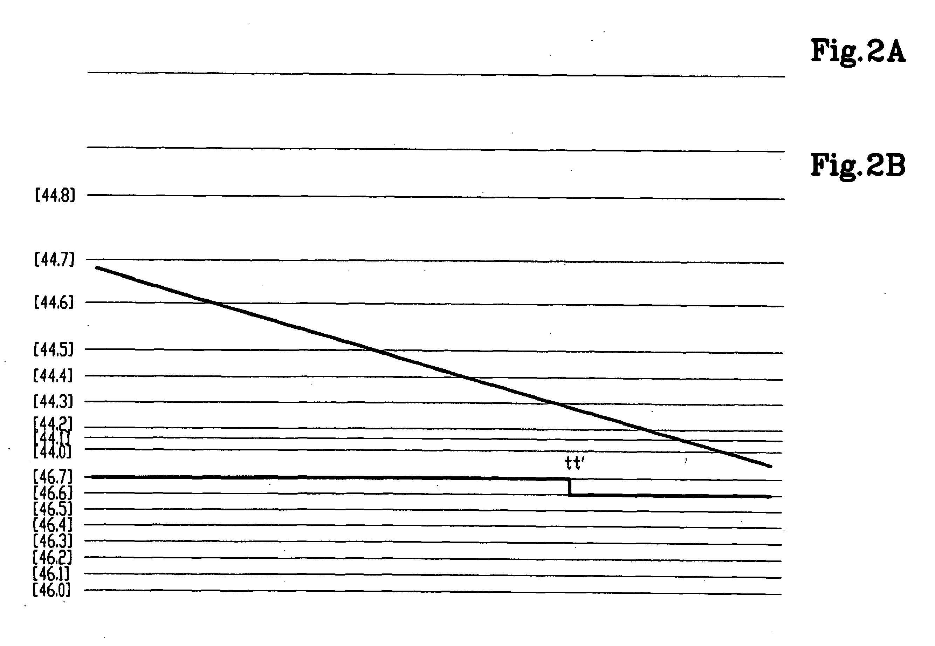

Der ersten Steuerungs-/Verarbeitungseinheit 204 werden die jeweiligen Ausgangssignale des Empfangsstörungsdetektors 10a, des Empfangsstörungsdetektors 10b sowie die Feldstärke 12 zugeführt; hierbei werden die Signale der Empfangsstörungsdetektoren 10a bzw. 10b nach jeweiliger Gewichtung, die in einer Gewichtungseinheit 20a bzw. 20b erfolgt, einem separaten Schwellentscheid in jeweils einer Schwellwerteinheit 22a bzw. 22b zugeführt, wie dies im Diagramm gemäß Figur 2A veranschaulicht ist [Abszisse oder Rechtsachse: Zeit t; Ordinate oder Hochachse: Ausgangssignal der Empfangsstörungsdetektoren 10a, 10b; waagrechte Linie: Schwellwert; die Unterteilung von Figur 2A auf zwei Blätter erfolgte allein aus darstellungstechnischen, nicht jedoch aus inhaltlichen Gründen]; bei diesem Schwellwertentscheid wird entschieden, ob es sich um eine Störung handelt, die deutlich und stark wahrnehmbar ist.

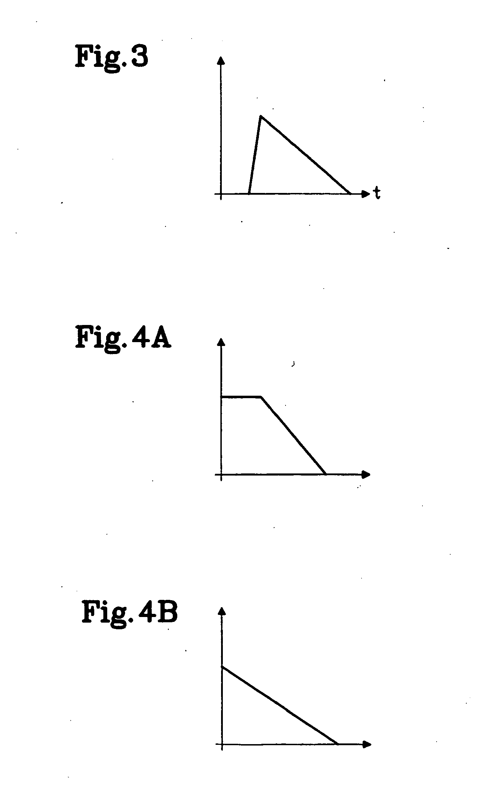

Nach dem Schwellentscheid werden die beiden Signale in einer ersten Logikeinheit 24 logisch ODER-verknüpft; das so gewonnene Ausgangssignal dient als Eingangssignal für eine durch eine erste Rampeneinheit 26 (vgl. Figur 1) vermittelte und in Figur 3 dargestellte unsymmetrische Rampe, die eine schnelle Anstiegszeit und eine langsame Abfallzeit aufweist (dementsprechend ist in Figur 3 die Zeit t auf der Abszisse oder Rechtsachse aufgetragen).

Hiernach wird das aus der Rampeneinheit 26 kommende Ausgangssignal einer Reset/Hold-Einheit 28 zugeführt, die folgende Betriebszustände aufweisen kann:
(a) Normalzustand: Ausgang = Eingang;
(b) Holdzustand: Ausgang wird unabhängig vom Eingang auf seinem Wert gehalten;
(c) Reset: Ausgang = 0.

Des weiteren wird in der in der oberen Hälfte von Figur 1 dargestellten Steuerung mit langsamer Verarbeitungsgeschwindigkeit, das heißt im für längere Zeiträume vorgesehenen ersten Verarbeitungszweig 204 das Feldstärkesignal 12 mittels einer ersten Kennlinieneinheit 30 einer Kennlinie zugeführt, deren ungefährer Verlauf in den Figuren 4A und 4B veranschaulicht ist [Abszisse oder Rechtsachse: Signal der Empfangsfeldstärke 12; Ordinate oder Hochachse: Ausgangssignal der ersten Kennlinieneinheit 30]:

Bei verschwindender oder geringer Empfangsfeldstärke 12 wird ein großes Ausgangssignal erzeugt, bei höherer Empfangsfeldstärke 12 wird ein kleines Ausgangssignal oder eine Null als Ausgangssignal erzeugt; der zwischen verschwindender Empfangsfeldstärke 12 und hoher Empfangsfeldstärke 12 verlaufende Zwischenbereich des Ausgangssignals weist zum Beispiel
- nach einem bei kleinen Empfangsfeldstärken 12 verlaufenden konstanten Wert einen proportional abfallenden Verlauf (vgl. Figur 4A) oder
- von vorneherein einen proportional abfallenden Verlauf (vgl. Figur 4B) auf. Das Signal hinter der Kennlinie wird ebenfalls einer Reset/Hold-Einheit 32 zugeführt, die im wesentlichen die gleichen Eigenschaften wie die erste, den Störungsdetektoren 10a, 10b nachgeschaltete Reset/Hold-Einheit 28 aufweist.

Aus den jeweiligen Signalen hinter den beiden Reset/Hold-Blöcken 28 bzw. 32 wird in einer ersten Komparatoreinheit 40 der Maximalwert M₁ (vgl. Figuren 1 und 2B; die Unterteilung von Figur 2B auf zwei Blätter erfolgte allein aus darstellungstechnischen, nicht jedoch aus inhaltlichen Gründen) gewonnen; dieser Maximalwert M₁ wiederum wird an die in der Schwellwerteinheit 42 erfolgende Schwellwertentscheidung weitergeleitet.

Hier wird das Eingangssignal der Schwellwerteinheit 42 mit neun Schwellen [44.0], [44.1], [44.2], [44.3], [44.4], [44.5], [44.6], [44.7], [44.8] verglichen; allerdings werden bei jedem Verarbeitungsdurchlauf nur drei Schwellentscheide durchgeführt; hierbei wird geprüft, ob
(i) das Eingangssignal größer als die aktuell gespeicherte Schwelle ist,
(ii) das Eingangssignal größer als die nächstgrößere Schwelle ist oder
(iii) das Eingangssignal kleiner als die aktuell gespeicherte Schwelle ist.

Auf diese Weise kann die Schwelle [44.0], [44.1], [44.2], [44.3], [44.4], [44.5], [44.6], [44.7], [44.8]
(i) beibehalten (zugelassene Veränderung Δ₁ = 0; vgl. Figur 1),
(ii) um eine Stufe erhöht (zugelassene Veränderung Δ₁ = +1; vgl. Figur 1) oder
(iii) um eine Stufe verringert (zugelassene Veränderung Δ₁ = -1; vgl. Figur 1)
werden.

Die Schwellwerte [44.0] und [44.8] stellen die Grenzen des Zahlenbereichs dar und sorgen für eine Begrenzung (vgl. Figur 2B). Das Verringern der Schwelle um eine Stufe (zugelassene Veränderung Δ₁ = -1; vgl. Figur 1) kann hierbei nur erfolgen, wenn eine Totzeit tt abgelaufen ist (--> Bezugszeichen tt^{v} in Figur 2B); diese Totzeit tt läuft, wenn das Eingangssignal kleiner als die aktuelle Schwelle ist (vgl. Figur 2B); ist das Eingangssignal für einen Verarbeitungsdurchlauf größer als die aktuelle Schwelle, so wird die Totzeit tt wieder zurückgesetzt (vgl. Figur 2B).

Dies soll am nachfolgenden Beispiel erläutert werden, das von Schwellwerten [44.0] = 0, [44.1] = 2.000, [44.2] = 4.000, [44.3] = 6.000, [44.4] = 8.000, [44.5] = 10.000, [44.6] = 12.000, [44.7] = 20.000, [44.8] = 32768 und von einer aktuell auf [44.3] = 6.000 gesetzten Schwelle ausgeht.
(i) Beträgt der Eingangswert 7.000, so ist das Eingangssignal (= der Eingangswert) größer als die aktuell gespeicherte Schwelle [44.3] = 6.000, jedoch nicht größer als die nächstgrößere Schwelle [44.4] = 8.000 (und natürlich nicht kleiner als die aktuell gespeicherte Schwelle [44.3] = 6.000), so daß die Schwelle beibehalten werden kann (zugelassene Veränderung Δ₁ = 0; vgl. Figur 1), das heißt die neue aktuelle Schwelle ist weiterhin [44.3] = 6.000.
(ii) Beträgt der Eingangswert 9.000, so ist das Eingangssignal (= der Eingangswert) nicht nur größer als die aktuell gespeicherte Schwelle [44.3] = 6.000, sondern auch größer als die nächstgrößere Schwelle [44.4] = 8.000 (und natürlich nicht kleiner als die aktuell gespeicherte Schwelle [44.3] = 6.000), so daß die Schwelle um eine Stufe erhöht werden kann (zugelassene Veränderung Δ₁ = +1; vgl. Figur 1), das heißt die neue aktuelle Schwelle ist dann [44.4] = 8.000.
(iii.a) Beträgt der Eingangswert hingegen 5.000 und ist die Totzeit tt nicht abgelaufen, so ist das Eingangssignal (= der Eingangswert) nicht größer als die aktuell gespeicherte Schwelle [44.3] = 6.000 und damit auch nicht größer als die nächstgrößere Schwelle [44.4] = 8.000, sondern vielmehr kleiner als die aktuell gespeicherte Schwelle [44.3] = 6.000; da die Totzeit tt nicht abgelaufen ist, ändert sich die aktuell gespeicherte Schwelle nicht, sondern beträgt weiterhin [44.3] = 6.000.
(iii.b) Beträgt der Eingangswert hingegen 1.000 und ist die Totzeit tt abgelaufen, so ist das Eingangssignal (= der Eingangswert) nicht größer als die aktuell gespeicherte Schwelle [44.3] = 6.000 und damit auch nicht größer als die nächstgrößere Schwelle [44.4] = 8.000, sondern vielmehr kleiner als die aktuell gespeicherte Schwelle [44.3] = 6.000, so daß die Schwelle um eine Stufe verringert werden kann (zugelassene Veränderung Δ₁ = -1; vgl. Figur 1), das heißt die neue aktuelle Schwelle ist [44.2] = 4.000.

Dem auf die Weise (i), (ii), (iii.a) oder (iii.b) ermittelten neuen Schwellwert wird nun ein Zeiger [46] (vgl. Figur 2B) der zur Verfügung stehenden Zeiger [46.0], [46.1], [46.2], [46.3], [46.4], [46.5], [46.6], [46.7] auf eine Filterkoeffiziententabelle 82 zugeordnet; so entspricht beispielsweise der Zeiger [46.2] der Schwelle [44.2], wie dem Diagramm gemäß Figur 2B entnehmbar ist.

Nachdem vorstehend die in der oberen Hälfte von Figur 1 dargestellte Steuerung mit langsamer Verarbeitungsgeschwindigkeit, das heißt der für längere Zeiträume vorgesehene erste Verarbeitungszweig 204 betrachtet wurde, soll im folgenden die in der unteren Hälfte von Figur 1 dargestellte Steuerung mit schneller Verarbeitungsgeschwindigkeit, das heißt der für kürzere Zeiträume vorgesehene zweite Verarbeitungszweig 507 betrachtet werden. Bei dieser "schnellen Steuerung" liegt die Abtastrate bei 9,5 Kilohertz, denn für eine nahezu verzögerungsfreie Reaktion auf Empfangsstörungen wird diese Abtastrate so hoch wie möglich.

Da die schnelle Steuerung 507 (= zweiter Verarbeitungszweig 507) prinzipiell der langsamen Steuerung 204 (= erster Verarbeitungszweig 204) sehr ähnlich ist, wird nachstehend zum Vermeiden unnötiger Wiederholungen nur auf die Unterschiede zwischen dem ersten Verarbeitungszweig 204 und dem zweiten Verarbeitungszweig 507 eingegangen; ansonsten gelten die vorstehend gemachten Aussagen, Beschreibungen und Erläuterungen sinngemäß auch vollumfänglich für den zweiten Verarbeitungszweig 507, wobei die dem zweiten Verarbeitungszweig 507 zugeordneten Bezugszeichen im Regelfall um die additive Konstante 30 höher als die dem ersten Verarbeitungszweig 204 zugeordneten Bezugszeichen gewählt sind.

Der zweite Verarbeitungszweig 507 weist keine Reset/Hold-Blöcke auf; vielmehr ist der Komparatoreinheit 70 von den beiden Empfangsstörungsdetektoren 10a, 10b kommend eine Skalierungseinheit 58 vorgeschaltet.

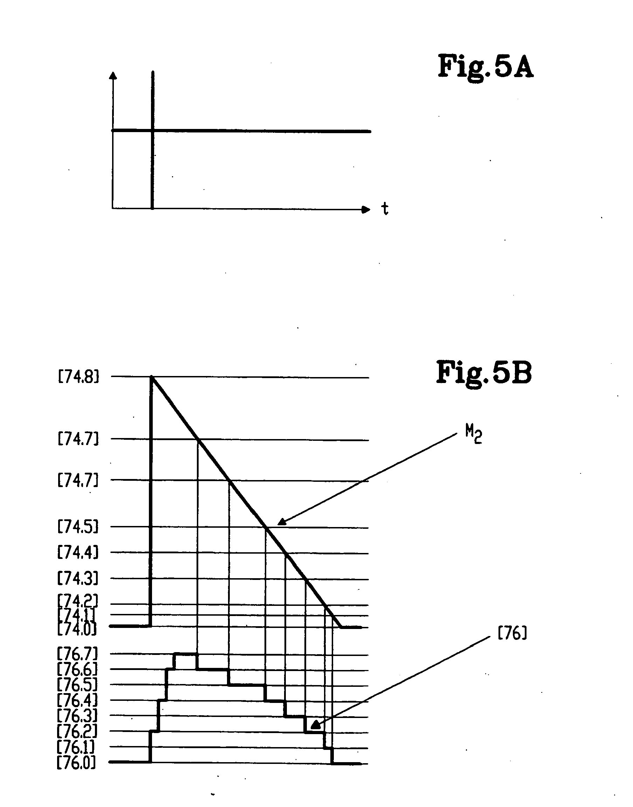

Des weiteren hat die Erzeugung der aktuellen Schwellwerte [74.0], [74.1], [74.2], [74.3], [74.4], [74.5], [74.6], [74.7], [74.8] insofern eine etwas andere Charakteristik, als die Schwelle [74.0], [74.1], [74.2], [74.3], [74.4], [74.5], [74.6], [74.7], [74.8] wiederum
(i) beibehalten (zugelassene Veränderung Δ₂ = 0; vgl. Figur 1),
(ii) um eine Stufe erhöht (zugelassene Veränderung Δ₂ = +1; vgl. Figur 1) oder
(iii) um eine Stufe verringert (zugelassene Veränderung Δ₂ = -1; vgl. Figur 1),
jedoch im Unterschied zur langsamen Steuerung 204 auch um zwei Stufen erhöht werden kann (zugelassene Veränderung Δ₂ = +2; vgl. Figur 1). Eine Totzeit tt existiert bei der schnellen Steuerung 507 nicht (vgl. Figur 5B).

Dem ermittelten Schwellwert [74.0], [74.1], [74.2], [74.3], [74.4], [74.5], [74.6], [74.7], [74.8] ist wiederum ein Zeiger [76] (vgl. Figur 5B) der zur Verfügung stehenden Zeiger [76.0], [76.1], [76.2], [76.3], [76.4], [76.5], [76.6], [76.7] auf dieselbe Filterkoeffiziententabelle 82 wie bei der langsamen Steuerung 204 zugeordnet; so entspricht beispielsweise der Zeiger [76.3] dem Schwellwert [74.3], wie dem Diagramm gemäß Figur 5B entnehmbar ist.

Nach Zusammenführen der langsamen Steuerung 204 und der schnellen Steuerung 507, das heißt ab der Komparatoreinheit 80 erfolgt die weitere Verarbeitung mit schneller Verarbeitungsgeschwindigkeit. Die jeweils erzeugten Zeiger [46] und [76] werden in der Komparatoreinheit 80 einer Maximalwertbildung zugeführt.

Das Ausgangssignal der Komparatoreinheit 80 enthält den ermittelten Zeiger M₃ (vgl. Figur 1) auf die Filterkoeffiziententabelle 82, das heißt den Maximalwert aus dem zugeordneten ersten Zeiger [46] des ersten Verarbeitungszweigs 204 und dem zugeordneten zweiten Zeiger [76] des zweiten Verarbeitungszweigs 507 (je nachdem, ob der erste Zeiger [46] oder der zweite Zeiger [76] größer ist).

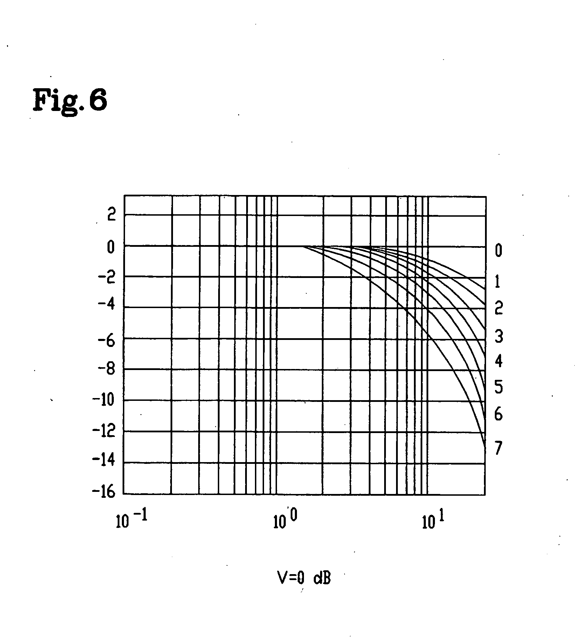

Derjenige Filterkoeffizient [84] der zur Verfügung stehenden Filterkoeffizienten (= Filterkurvenstufen [84.0], [84.1], [84.2], [84.3], [84.4], [84.5], [84.6], [84.7]), auf den der ermittelte Zeiger M₃ weist, wird nun an das HiCut-Filter 94 übertragen und eingestellt. Die Diagramm gemäß Figur 6 [Abszisse oder Rechtsachse: Frequenz in Kilohertz (logarithmische Darstellung); Ordinate oder Hochachse: Dämpfung in Dezibel] zeigt ein Beispiel der Einstellung der acht zur Verfügung stehenden Filterkurven (sogenannte "HiCut"-Filterkurven), die in Figur 6 mit den Ziffern 0, 1, 2, 3, 4, 5, 6 und 7 bezeichnet sind.

Durch die Steuerung der Filterkoeffizienten [84.0], [84.1], [84.2], [84.3], [84.4], [84.5], [84.6], [84.7] mit einem ermittelten Zeiger M₃ im Speicher ist die Steuerung unabhängig von der Art und von der Ordnung des Filters 94, denn in erfindungswesentlicher Weise können dem ermittelten Zeiger wahlweise ein oder mehrere Filterkoeffizienten [84.0], [84.1], [84.2], [84.3], [84.4], [84.5], [84.6], [84.7] zugeordnet werden; dies hat den Vorteil, daß die Steuerung im wesentlichen unabhängig von der Audioverarbeitung ist; des weiteren kann hierdurch eine nichtlineare Zuordnung der Steuergröße zu den Filterkurven im HiCut-Filter 94 erzielt werden.

Ergänzend sei noch ausgeführt, daß das Fehlen von Reset/Hold-Blöcken im zweiten Verarbeitungszweig 507 bzw. das Vorhandensein der Reset/Hold-Blöcke 28, 32 im ersten Verarbeitungszweig 204 sich aus der technischen Bedingung erklärt, im ersten Verarbeitungszweig 204 ein schnelles Zurücksetzen oder ein Halten der aktuellen Einstellung hervorzurufen:

Wird ein stark gestörter Sender empfangen, so wird die HiCut-Funktion die Höhen stark bedämpfen. Wird nun der Sender gewechselt, so soll dieser neue Sender sofort ohne Höhenabsenkung empfangbar sein. Zu diesem Zweck wird die Reset-Funktionalität eingesetzt.

Die Hold-Funktionalität wird verwendet, um den Zustand der langsamen HiCut-Funktion während eines R[adio]D[aten]S[ystem]-A[lternativ]F[requenz]-Tests einzufrieren; durch das Halten der Einstellung wird sichergestellt, daß sich der Höreindruck vor dem A[lternativ]F[requenz]-Test nicht vom Höreindruck nach dem A[lternativ]F[requenz]-Test unterscheidet.

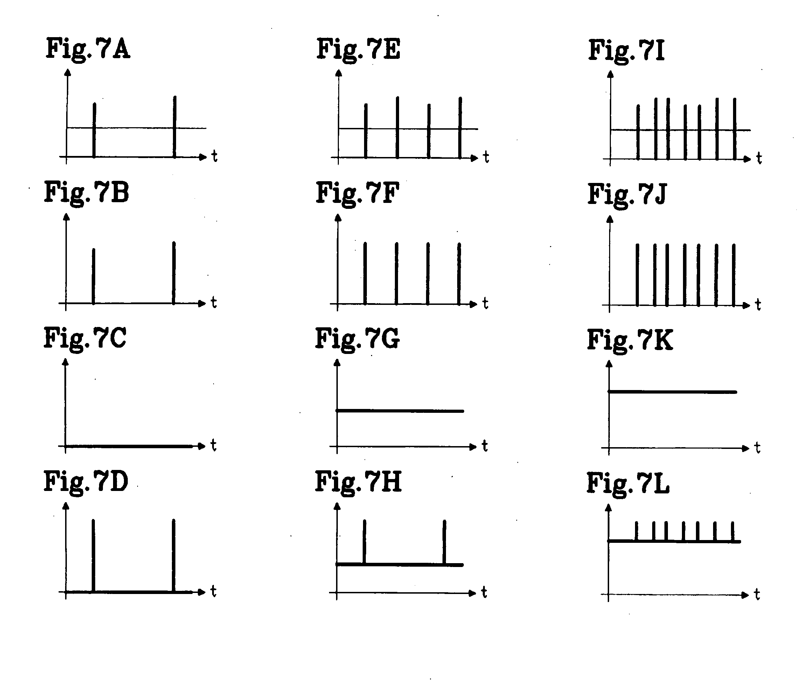

Abschließend wird die prinzipielle Verfahrensweise gemäß der vorliegenden Erfindung anhand der Figuren 7A bis 7L [Abszisse oder Rechtsachse in den Figuren 7A bis 7L: Zeit t; Ordinate oder Hochachse in den Figuren 7A, 7E, 7I: Ausgangssignal der Empfangsstörungsdetektoren 10a, 10b; waagrechte Linie in den Figuren 7A, 7E, 7I: Schwellwert; Ordinate oder Hochachse in den Figuren 7B, 7F, 7J: Signal bei "schneller Steuerung", das heißt im zweiten Verarbeitungszweig 507; Ordinate oder Hochachse in den Figuren 7C, 7G, 7K: Signal bei "langsamer Steuerung", das heißt im ersten Verarbeitungszweig 204; Ordinate oder Hochachse in den Figuren 7D, 7H, 7L: Signal nach Maximumbildung, das heißt resultierendes Signal der Maximalwertbildung] nochmals veranschaulicht.

In diesem Zusammenhang bezieht sich der linke Teil (= Figuren 7A, 7B, 7C, 7D) der graphischen Darstellung auf den Fall sporadischer Störungen; der mittlere Teil (= Figuren 7E, 7F, 7G, 7H) der graphischen Darstellung betrifft den Fall einer mittleren oder durchschnittlichen Störhäufigkeit, wohingegen sich der rechte Teil (= Figuren 7I, 7J, 7K, 7L) der graphischen Darstellung auf den Fall einer hohen Störhäufigkeit bezieht.

Bei nur sporadisch oder vereinzelt auftretenden Störungen (vgl. Figur 7A) wird die Höhenabsenkung durch die langsame Steuerung klein, unter Umständen verschwindet die Höhenabsenkung sogar, das heißt ist gar nicht vorhanden (vgl. Figur 7C); in diesem Falle wirkt nur die für kurze Zeit ansprechende schnelle Steuerung (vgl. Figur 7B), was zu dem in Figur 7D gezeigten Signal nach Maximumbildung führt.

Bei häufigen Störungen (= hohe Störhäufigkeit; vgl. Figur 7I) gibt es zwei Möglichkeiten: Sind die Dynamik der schnellen Steuerung (vgl. Figur 7J) und die Dynamik der langsamen Steuerung (vgl. Figur 7K) gleich, so ergibt sich nach der Maximalwertbildung das Signal der langsamen Steuerung (vgl. Figur 7L); ist hingegen die Dynamik der schnellen Steuerung (vgl. Figur 7J) größer als die Dynamik der langsamen Steuerung (vgl. Figur 7K), so werden auch bei häufig auftretenden Störungen kurze Absenkungen um die Differenz der Dynamik der beiden Steuerungen addiert (vgl. Figur 7L).

Im Übergangsbereich (vgl. Figuren 7E, 7F, 7G, 7H) zwischen sporadischen Störungen (vgl. Figuren 7A, 7B, 7C, 7D) und häufigen Störungen (vgl. Figuren 7I, 7J, 7K, 7L) erfolgt eine Kombination aus schneller Steuerung (vgl. Figur 7F) und aus langsamer Steuerung (vgl. Figur 7G); in diesem Falle erfolgt in erfindungswesentlicher Weise eine Höhenabsenkung mit langsamer Zeitkonstante und additiv eine kurzzeitige schnelle Höhenabsenkung mit geringer Dynamik nur beim Auftreten der Störung.

Dies bedeutet, daß die mittels der schnellen Steuerung (vgl. Figur 7F) und/oder mittels der langsamen Steuerung (vgl. Figur 7G) bewerkstelligte Höhenabsenkung (= Verringern der Höhenwiedergabe des wiederzugebenden Audiosignals 90, 92) durch eine Maximalwertbildung (vgl. Figur 7H) überlagert wird. Bei Störungen mit mittlerer Häufigkeit wird sich die Höhenabsenkung der langsamen Steuerung (vgl. Figur 7G) also auf einen mittleren Wert einstellen; in diesem Falle ergibt sich während des Ansprechens der schnellen Steuerung (vgl. Figur 7F) eine größere Höhenabsenkung.

### Bezugszeichenliste

- 100: Schaltungsanordnung
- 10a: erster Empfangsstörungsdetektor
- 10b: zweiter Empfangsstörungsdetektor
- 12: Empfangsfeldstärke
- 20a: erste Gewichtungseinheit
- 20b: zweite Gewichtungseinheit
- 22a: erste Schwellwerteinheit
- 22b: zweite Schwellwerteinheit
- 24: erste Logikeinheit, insbesondere erste ODER-Logikeinheit
- 26: erste Rampeneinheit
- 28: erste Reset/Hold-Einheit
- 30: erste Kennlinieneinheit
- 32: zweite Reset/Hold-Einheit
- 40: erste Komparatoreinheit
- 42: dritte Schwellwerteinheit
- [44i]: neuer erster Schwellwert (i = 0; 1; 2; 3; 4; 5; 6; 7; 8)
- [46j]: zur Verfügung stehender erster Zeiger (j = 0; 1; 2; 3; 4; 5; 6; 7)
- [46]: zugeordneter erster Zeiger
- 50a: dritte Gewichtungseinheit
- 50b: vierte Gewichtungseinheit
- 52a: vierte Schwellwerteinheit
- 52b: fünfte Schwellwerteinheit
- 54: zweite Logikeinheit, insbesondere zweite ODER-Logikeinheit
- 56: zweite Rampeneinheit
- 58: Skalierungseinheit
- 60: zweite Kennlinieneinheit
- 70: zweite Komparatoreinheit
- 72: sechste Schwellwerteinheit
- [74i]: neuer zweiter Schwellwert (i = 0; 1; 2; 3; 4; 5; 6; 7; 8)
- [76j]: zur Verfügung stehender zweiter Zeiger (j = 0; 1; 2; 3; 4; 5; 6; 7)
- [76]: zugeordneter zweiter Zeiger
- 80: dritte Komparatoreinheit
- 82: Filterkoeffiziententabelle
- [84j]: zur Verfügung stehender Filterkoeffizient (j = 0; 1; 2; 3; 4; 5; 6; 7)
- [84]: zugeordneter Filterkoeffizient
- 90: Audiosignal (L[inks]-Kanal des Stereokanals) vor Filtereinheit 94
- 92: Audiosignal (R[echts]-Kanal des Stereokanals) vor Filtereinheit 94
- 94: Filtereinheit
- 96: Audiosignal (L[inks]-Kanal des Stereokanals) hinter Filtereinheit 94
- 98: Audiosignal (R[echts]-Kanal des Stereokanals) hinter Filtereinheit 94
- 204: erster Verarbeitungszweig mit erster Abtastrate
- 507: zweiter Verarbeitungszweig mit zweiter Abtastrate
- Δ₁: zugelassene Veränderung im ersten Verarbeitungszweig 204
- Δ₂: zugelassene Veränderung im zweiten Verarbeitungszweig 507
- M₁: Maximalwert im ersten Verarbeitungszweig 204
- M₂: Maximalwert im zweiten Verarbeitungszweig 507
- M₃: Maximalwert aus zugeordnetem erstem Zeiger [46] und zugeordnetem zweitem Zeiger [76]
- t: Zeit
- tt: Totzeit
- tt?: Totzeit?
- tt^{v}: Totzeit abgelaufen

## Patentansprüche

1. Verfahren zum Beeinflussen, insbesondere zum Verringern, der Höhenwiedergabe eines wiederzugebenden, aus einem empfangenen Signal gewonnenen Audiosignals (90, 92), wobei die Empfangsfeldstärke (12) sowie die Empfangsqualität des empfangenen Signals ausgewertet werden und in Abhängigkeit hiervon die Übertragungsfunktion mindestens einer mit dem Audiosignal (90, 92) beaufschlagbaren Filtereinheit (94) gesteuert wird,
**dadurch gekennzeichnet,**
- **dass** das Verarbeiten der Ausgangssignale mindestens zweier Empfangsstörungsdetektoren (10a, 10b) sowie das Verarbeiten der Empfangsfeldstärke (12) jeweils
-- in mindestens einem ersten, mit einer ersten, insbesondere variablen Abtastrate arbeitenden Verarbeitungszweig (204) und
-- in mindestens einem zweiten, mit einer zweiten Abtastrate arbeitenden Verarbeitungszweig (507) erfolgt und
- **dass** die erste Abtastrate niedriger als die zweite Abtastrate eingestellt wird derart,
- **dass** die Höhenwiedergabe mittels des ersten Verarbeitungszweigs (204) für längere Zeiträume als mittels des zweiten Verarbeitungszweigs (507) bedämpft werden kann.

2. Verfahren gemäß Anspruch 1, **dadurch gekennzeichnet,**
- **dass** im ersten Verarbeitungszweig (204)
(a.1) das Ausgangssignal des ersten Empfangsstörungsdetektors (10a) in mindestens einer ersten Gewichtungseinheit (20a) gewichtet wird,
(a.2) das Ausgangssignal der ersten Gewichtungseinheit (20a) in mindestens einer ersten Schwellwerteinheit (22a) mindestens einem Schwellwertentscheid zugeführt wird,
(a.3) das Ausgangssignal des zweiten Empfangsstörungsdetektors (10b) in mindestens einer zweiten Gewichtungseinheit (20b) gewichtet wird,
(a.4) das Ausgangssignal der zweiten Gewichtungseinheit (20b) in mindestens einer zweiten Schwellwerteinheit (22b) mindestens einem Schwellwertentscheid zugeführt wird,
(a.5) das Ausgangssignal der ersten Schwellwerteinheit (22a) und das Ausgangssignal der zweiten Schwellwerteinheit (22b) in mindestens einer ersten Logikeinheit (24) einer logischen ODER-Verknüpfung unterzogen werden,
(a.6) das Ausgangssignal der ersten Logikeinheit (24) in mindestens einer ersten Rampeneinheit (26) einer asymmetrischen, eine kurze Anstiegszeit und eine lange Abfallzeit aufweisenden Rampe zugeführt wird,
(a.7) das Ausgangssignal der ersten Rampeneinheit (26) mindestens einer ersten Reset/Hold-Einheit (28) zugeführt wird,
(b.1) das Signal der Empfangsfeldstärke (12) in mindestens einer ersten Kennlinieneinheit (30) einer ersten Kennlinie zugeführt wird derart,
(b.1.1) dass bei niedriger Empfangsfeldstärke (12) ein hohes Ausgangssignal der ersten Kennlinieneinheit (30) erzeugt wird und
(b.1.2) dass bei hoher Empfangsfeldstärke (12) ein niedriges oder verschwindendes Ausgangssignal der ersten Kennlinieneinheit (30) erzeugt wird,
(b.2) das Ausgangssignal der ersten Kennlinieneinheit (30) mindestens einer zweiten Reset/Hold-Einheit (32) zugeführt wird,
(c.1) das Ausgangssignal der ersten Reset/Hold-Einheit (28) und das Ausgangssignal der zweiten Reset/Hold-Einheit (32) in mindestens einer ersten Komparatoreinheit (40) einer Maximalwertbildung zugeführt werden,
(c.2) das Ausgangssignal (M₁) der ersten Komparatoreinheit (40) in mindestens einer dritten Schwellwerteinheit (42) mindestens einem Schwellwertentscheid zugeführt wird, so dass mindestens ein neuer erster Schwellwert ([44.0]; [44.1]; [44.2]; [44.3]; [44.4]; [44.5]; [44.6]; [44.7]; [44.8]) gebildet wird, und
(c.3) dem neuen ersten Schwellwert ([44.0]; [44.1]; [44.2]; [44.3]; [44.4]; [44.5]; [44.6]; [44.7]; [44.8]) der dritten Schwellwerteinheit (42) mindestens ein erster Zeiger ([46]) auf eine der Filtereinheit (94) zugeordnete Filterkoeffiziententabelle (82) zugeordnet wird und/oder
- **dass** im zweiten Verarbeitungszweig (507)
(d.1) das Ausgangssignal des ersten Empfangsstörungsdetektors (10a) in mindestens einer dritten Gewichtungseinheit (50a) gewichtet wird,
(d.2) das Ausgangssignal der dritten Gewichtungseinheit (50a) in mindestens einer vierten Schwellwerteinheit (52a) mindestens einem Schwellwertentscheid zugeführt wird,
(d.3) das Ausgangssignal des zweiten Empfangsstörungsdetektors (10b) in mindestens einer vierten Gewichtungseinheit (50b) gewichtet wird,
(d.4) das Ausgangssignal der vierten Gewichtungseinheit (50b) in mindestens einer fünften Schwellwerteinheit (52b) mindestens einem Schwellwertentscheid zugeführt wird,
(d.5) das Ausgangssignal der vierten Schwellwerteinheit (52a) und das Ausgangssignal der fünften Schwellwerteinheit (52b) in mindestens einer zweiten Logikeinheit (54) einer logischen ODER-Verknüpfung unterzogen werden,
(d.6) das Ausgangssignal der zweiten Logikeinheit (54) in mindestens einer zweiten Rampeneinheit (56) einer asymmetrischen, eine kurze Anstiegszeit und eine lange Abfallzeit aufweisenden Rampe zugeführt wird,
(d.7) das Ausgangssignal der zweiten Rampeneinheit (56) einer Skalierungseinheit (58) zugeführt wird,
(e.1) das Signal der Empfangsfeldstärke (12) in mindestens einer zweiten Kennlinieneinheit (60) einer zweiten Kennlinie zugeführt wird derart,
(e.1.1) dass bei niedriger Empfangsfeldstärke (12) ein hohes Ausgangssignal der zweiten Kennlinieneinheit (60) erzeugt wird und
(e.1.2) dass bei hoher Empfangsfeldstärke (12) ein niedriges oder verschwindendes Ausgangssignal der zweiten Kennlinieneinheit (60) erzeugt wird,
(f.1) das Ausgangssignal der Skalierungseinheit (58) und das Ausgangssignal der zweiten Kennlinieneinheit (60) in mindestens einer zweiten Komparatoreinheit (70) einer Maximalwertbildung zugeführt werden,
(f.2) das Ausgangssignal (M₂) der zweiten Komparatoreinheit (70) in mindestens einer sechsten Schwellwerteinheit (72) mindestens einem Schwellwertentscheid zugeführt wird, so dass mindestens ein neuer zweiter Schwellwert ([74.0]; [74.1]; [74.2]; [74.3]; [74.4]; [74.5]; [74.6]; [74.7]; [74.8]) gebildet wird, und
(f.3) dem neuen zweiten Schwellwert ([74.0]; [74.1]; [74.2]; [74.3]; [74.4]; [74.5]; [74.6]; [74.7]; [74.8]) der sechsten Schwellwerteinheit (72) mindestens ein zweiter Zeiger ([76]) auf eine der Filtereinheit (94) zugeordnete Filterkoeffiziententabelle (82) zugeordnet wird.

3. Verfahren gemäß Anspruch 2, **dadurch gekennzeichnet, dass**
(g.1) der erste Zeiger ([46]) und der zweite Zeiger ([76]) in mindestens einer dritten Komparatoreinheit (80) einer Maximalwertbildung zugeführt werden und
(g.2) der mindestens eine Filterkoeffizient ([84.0]; [84.1]; [84.2]; [84.3]; [84.4]; [84.5]; [84.6]; [84.7]) der Filterkoeffiziententabelle (82), auf den das Ausgangssignal (M₃) der dritten Komparatoreinheit (80) weist, an die Filtereinheit (94) übertragen wird.

4. Verfahren gemäß mindestens einem der Ansprüche 1 bis 3, **dadurch gekennzeichnet, dass**
- der erste Verarbeitungszweig (204) mit einer ersten Abtastrate in der Größenordnung von 0 Hertz bis etwa 950 Hertz arbeitet, so dass die Höhenwiedergabe mittels des ersten Verarbeitungszweigs (204) für Zeiträume von bis zu etwa dreißig Sekunden bedämpft werden kann, und/oder
- der zweite Verarbeitungszweig (507) mit einer zweiten Abtastrate in der Größenordnung von etwa 9,5 Kilohertz arbeitet, so dass die Höhenwiedergabe mittels des zweiten Verarbeitungszweigs (507) für Zeiträume von wesentlich kürzer als dreißig Sekunden bedämpft werden kann.

5. Verfahren gemäß mindestens einem der Ansprüche 1 bis 4, **dadurch gekennzeichnet, dass** die Steuerung des Beeinflussens, insbesondere des Verringerns, der Höhenwiedergabe des Audiosignals (90, 92) derart an eine Steuerung, insbesondere an ein Reduzieren, der Trennung des L[inks]-Kanals (90) und des R[echts]-Kanals (92) des Audiosignals (90, 92) gekoppelt wird, dass zumindest für den ersten Verarbeitungszweig (204) und zumindest für den langsameren Teil der Steuerung der Trennung des L[inks]-Kanals (90) und des R[echts]-Kanals (92) des Audiosignals (90, 92) dieselben Komponenten, insbesondere dieselben Detektoren und dieselben Schwellentscheide, eingesetzt werden.

6. Schaltungsanordnung (100) zum Beeinflussen, insbesondere zum Verringern, der Höhenwiedergabe eines wiederzugebenden, aus einem empfangenen Signal gewonnenen Audiosignals (90, 92), wobei die Empfangsfeldstärke (12) sowie die Empfangsqualität des empfangenen Signals auswertbar sind und in Abhängigkeit hiervon die Übertragungsfunktion mindestens einer mit dem Audiosignal (90, 92) beaufschlagbaren Filtereinheit (94) steuerbar ist,
**dadurch gekennzeichnet,**
- **dass** mindestens zwei Empfangsstörungsdetektoren (10a, 10b) vorgeschaltet sind, deren Ausgangssignale ebenso wie die Empfangsfeldstärke (12)
-- in mindestens einem ersten, mit einer ersten, insbesondere variablen Abtastrate arbeitenden Verarbeitungszweig (204) und
-- in mindestens einem zweiten, mit einer zweiten Abtastrate arbeitenden Verarbeitungszweig (507)
verarbeitbar sind, und
- **dass** die erste Abtastrate niedriger als die zweite Abtastrate ist derart,
- **dass** die Höhenwiedergabe mittels des ersten Verarbeitungszweigs (204) für längere Zeiträume als mittels des zweiten Verarbeitungszweigs (507) bedämpfbar ist.

7. Schaltungsanordnung gemäß Anspruch 6, **dadurch gekennzeichnet,**
- **dass** der erste Verarbeitungszweig (204)
-- mindestens eine erste Gewichtungseinheit (20a), in der das Ausgangssignal des ersten Empfangsstörungsdetektors (10a) gewichtbar ist,
-- mindestens eine erste Schwellwerteinheit (22a), in der das Ausgangssignal der ersten Gewichtungseinheit (20a) mindestens einem Schwellwertentscheid zuführbar ist,
-- mindestens eine zweite Gewichtungseinheit (20b), in der das Ausgangssignal des zweiten Empfangsstörungsdetektors (10b) gewichtbar ist,
-- mindestens eine zweite Schwellwerteinheit (22b), in der das Ausgangssignal der zweiten Gewichtungseinheit (20b) mindestens einem Schwellwertentscheid zuführbar ist,
-- mindestens eine erste Logikeinheit (24), in der das Ausgangssignal der ersten Schwellwerteinheit (22a) und das Ausgangssignal der zweiten Schwellwerteinheit (22b) einer logischen ODER-Verknüpfung zuführbar sind,
-- mindestens eine erste Rampeneinheit (26), in der das Ausgangssignal der ersten Logikeinheit (24) einer asymmetrischen, eine kurze Anstiegszeit und eine lange Abfallzeit aufweisenden Rampe zuführbar ist,
-- mindestens eine erste Reset/Hold-Einheit (28), der das Ausgangssignal der ersten Rampeneinheit (26) zuführbar ist,
-- mindestens eine erste Kennlinieneinheit (30), in der das Signal der Empfangsfeldstärke (12) einer ersten Kennlinie zuführbar ist derart,
--- dass bei niedriger Empfangsfeldstärke (12) ein hohes Ausgangssignal der ersten Kennlinieneinheit (30) erzeugbar ist und
--- dass bei hoher Empfangsfeldstärke (12) ein niedriges oder verschwindendes Ausgangssignal der ersten Kennlinieneinheit (30) erzeugbar ist,
-- mindestens eine zweite Reset/Hold-Einheit (32), der das Ausgangssignal der ersten Kennlinieneinheit (30) zuführbar ist,
-- mindestens eine erste Komparatoreinheit (40), in der das Ausgangssignal der ersten Reset/Hold-Einheit (28) und das Ausgangssignal der zweiten Reset/Hold-Einheit (32) einer Maximalwertbildung zuführbar sind,
-- mindestens eine dritte Schwellwerteinheit (42), in der das Ausgangssignal (M₁) der ersten Komparatoreinheit (40) mindestens einem Schwellwertentscheid zuführbar ist, um mindestens einen neuen ersten Schwellwert ([44.0]; [44.1]; [44.2]; [44.3]; [44.4]; [44.5]; [44.6]; [44.7]; [44.8]) zu bilden, dem mindestens ein erster Zeiger ([46]) auf eine der Filtereinheit (94) zugeordnete Filterkoeffiziententabelle (82) zuordbar ist,
aufweist und/oder
- **dass** der zweite Verarbeitungszweig (507)
-- mindestens eine dritte Gewichtungseinheit (50a), in der das Ausgangssignal des ersten Empfangsstörungsdetektors (10a) gewichtbar ist,
-- mindestens eine vierte Schwellwerteinheit (52a), in der das Ausgangssignal der dritten Gewichtungseinheit (50a) einem Schwellwertentscheid zuführbar ist,
-- mindestens eine vierte Gewichtungseinheit (50b), in der das Ausgangssignal des zweiten Empfangsstörungsdetektors (10b) gewichtbar ist,
-- mindestens eine fünfte Schwellwerteinheit (52b), in der das Ausgangssignal der vierten Gewichtungseinheit (50b) einem Schwellwertentscheid zuführbar ist,
-- mindestens eine zweite Logikeinheit (54), in der das Ausgangssignal der vierten Schwellwerteinheit (52a) und das Ausgangssignal der fünften Schwellwerteinheit (52b) einer logischen ODER-Verknüpfung zuführbar sind,
-- mindestens eine zweite Rampeneinheit (56), in der das Ausgangssignal der zweiten Logikeinheit (54) einer asymmetrischen, eine kurze Anstiegszeit und eine lange Abfallzeit aufweisenden Rampe zuführbar ist,
-- mindestens eine Skalierungseinheit (58), der das Ausgangssignal der zweiten Rampeneinheit (56) zuführbar ist,
-- mindestens eine zweite Kennlinieneinheit (60), in der das Signal der Empfangsfeldstärke (12) einer zweiten Kennlinie zuführbar ist derart,
--- dass bei niedriger Empfangsfeldstärke (12) ein hohes Ausgangssignal der zweiten Kennlinieneinheit (60) erzeugbar ist und
--- dass bei hoher Empfangsfeldstärke (12) ein niedriges oder verschwindendes Ausgangssignal der zweiten Kennlinieneinheit (60) erzeugbar ist,
-- mindestens eine zweite Komparatoreinheit (70), in der das Ausgangssignal der Skalierungseinheit (58) und das Ausgangssignal der zweiten Kennlinieneinheit (60) einer Maximalwertbildung zuführbar sind,
-- mindestens eine sechste Schwellwerteinheit (72), in der das Ausgangssignal (M₂) der zweiten Komparatoreinheit (70) mindestens einem Schwellwertentscheid zuführbar ist, um mindestens einen neuen zweiten Schwellwert ([74.0]; [74.1]; [74.2]; [74.3]; [74.4]; [74.5]; [74.6]; [74.7]; [74.8]) zu bilden, dem mindestens ein zweiter Zeiger ([76]) auf eine der Filtereinheit (94) zugeordnete Filterkoeffiziententabelle (82) zuordbar ist, aufweist.

8. Schaltungsanordnung gemäß Anspruch 7, **gekennzeichnet durch** mindestens eine dritte Komparatoreinheit (80), in der der erste Zeiger ([46]) und der zweite Zeiger ([76]) einer Maximalwertbildung zuführbar sind, wobei der mindestens eine Filterkoeffizient ([84.0]; [84.1]; [84.2]; [84.3]; [84.4]; [84.5]; [84.6]; [84.7]) der Filterkoeffiziententabelle (82), auf den das Ausgangssignal (M₁₃) der dritten Komparatoreinheit (80) weist, an die Filtereinheit (94) übertragbar ist.

9. Schaltungsanordnung gemäß mindestens einem der Ansprüche 6 bis 8, **dadurch gekennzeichnet, dass**
- der erste Verarbeitungszweig (204) eine erste Abtastrate in der Größenordnung von 0 Hertz bis etwa 950 Hertz aufweist, so dass die Höhenwiedergabe mittels des ersten Verarbeitungszweigs (204) für Zeiträume von bis zu etwa dreißig Sekunden bedämpfbar ist, und/oder
- der zweite Verarbeitungszweig (507) eine zweite Abtastrate in der Größenordnung von etwa 9,5 Kilohertz aufweist, so dass die Höhenwiedergabe mittels des zweiten Verarbeitungszweigs (507) für Zeiträume von wesentlich kürzer als dreißig Sekunden bedämpfbar ist.

10. Verwendung eines Verfahrens gemäß mindestens einem der Ansprüche 1 bis 5 und/oder mindestens einer Schaltungsanordnung (100) gemäß mindestens einem der Ansprüche 6 bis 9 zum Beeinflussen, insbesondere zum Verringern, der Höhenwiedergabe eines wiederzugebenden, aus einem empfangenen Rundfunksignal gewonnenen Audiosignals (90, 92) in mindestens einem Rundfunkempfänger, insbesondere in mindestens einem Rundfunkempfänger mit digitale Zwischen-Frequenz-Verarbeitung.

## Claims

1. Method for influencing, particularly for reducing, the treble reproduction of an audio signal (90, 92) to be reproduced which is obtained from a received signal, wherein the reception field strength (12) and the reception quality of the received signal are evaluated and this is taken as a basis for controlling the transfer function of at least one filter unit (94) to which the audio signal (90, 92) can be applied, **characterized**
- **in that** the processing of the output signals from at least two reception noise detectors (10a, 10b) and the processing of the reception field strength (12) each take place
-- in at least one first processing path (204) operating at a first, in particular variable sampling rate and
-- in at least one second processing path (507) operating at a second sampling rate, and
- **in that** the first sampling rate is set lower than the second sampling rate such
- that the treble reproduction can be attenuated for longer periods using the first processing path (204) than using the second processing path (507).

2. Method according to Claim 1, **characterized**
- **in that** in the first processing path (204)
(a.1) the output signal from the first reception noise detector (10a) is weighted in at least one first weighting unit (20a),
(a.2) the output signal from the first weighting unit (20a) is supplied to at least one threshold value decision in at least one first threshold value unit (22a),
(a.3) the output signal from the second reception noise detector (10b) is weighted in at least one second weighting unit (20b),
(a.4) the output signal from the second weighting unit (20b) is supplied to at least one threshold value decision in at least one second threshold value unit (22b),
(a.5) the output signal from the first threshold value unit (22a) and the output signal from the second threshold value unit (22b) are subjected to logic ORing in at least one first logic unit (24),
(a.6) the output signal from the first logic unit (24) is supplied to an asymmetric ramp, having a short rise time and a long fall time, in at least one first ramp unit (26),
(a.7) the output signal from the first ramp unit (26) is supplied to at least one first reset/hold unit (28),
(b.1) the signal from the reception field strength (12) is supplied to a first characteristic curve in at least one first characteristic curve unit (30) such
(b.1.1) that at low reception field strength (12) a high output signal from the first characteristic curve unit (30) is produced and
(b.1.2) that at high reception field strength (12) a low or exceedingly low output signal from the first characteristic curve unit (30) is produced,
(b.2) the output signal from the first characteristic curve unit (30) is supplied to at least one second reset/hold unit (32),
(c.1) the output signal from the first reset/hold unit (28) and the output signal from the second reset/hold unit (32) are supplied to maximum value formation in at least one first comparator unit (40),
(c.2) the output signal (M₁) from the first comparator unit (40) is supplied to at least one threshold value decision in at least one third threshold value unit (42), so that at least one new first threshold value ([44.0]; [44.1]; [44.2]; [44.3]; [44.4]; [44.5]; [44.6]; [44.7]; [44.8]) is formed, and
(c.3) the new first threshold value ([44.0]; [44.1]; [44.2]; [44.3]; [44.4]; [44.5]; [44.6]; [44.7]; [44.8]) from the third threshold value unit (42) is assigned at least one first pointer ([46]) to a filter coefficient table (82) associated with the filter unit (94), and/or
- **in that** in the second processing path (507)
(d.1) the output signal from the first reception noise detector (10a) is weighted in at least one third weighting unit (50a),
(d.2) the output signal from the third weighting unit (50a) is supplied to at least one threshold value decision in at least one fourth threshold value unit (52a),
(d.3) the output signal from the second reception noise detector (10b) is weighted in at least one fourth weighting unit (50b),
(d.4) the output signal from the fourth weighting unit (50b) is supplied to at least one threshold value decision in at least one fifth threshold value unit (52b),
(d.5) the output signal from the fourth threshold value unit (52a) and the output signal from the fifth threshold value unit (52b) are subjected to logic ORing in at least one second logic unit (54),
(d.6) the output signal from the second logic unit (54) is supplied to an asymmetric ramp, having a short rise time and a long fall time, in at least one second ramp unit (56),
(d.7) the output signal from the second ramp unit (56) is supplied to a scaling unit (58),
(e.1) the signal from the reception field strength (12) is supplied to a second characteristic curve in at least one second characteristic curve unit (60) such
(e.1.1) that at low reception field strength (12) a high output signal from the second characteristic curve unit (60) is produced and
(e.1.2) that at high reception field strength (12) a low or exceedingly low output signal from the second characteristic curve unit (60) is produced,
(f.1) the output signal from the scaling unit (58) and the output signal from the second characteristic curve unit (60) are supplied to maximum value formation in at least one second comparator unit (70),
(f.2) the output signal (M₂) from the second comparator unit (70) is supplied to at least one threshold value decision in at least one sixth threshold value unit (72), so that at least one new second threshold value ([74.0]; [74.1]; [74.2]; [74.3]; [74.4]; [74.5]; [74.6]; [74.7]; [74.8]) is formed, and
(f.3) the new second threshold value ([74.0]; [74.1]; [74.2]; [74.3]; [74.4]; [74.5]; [74.6]; [74.7]; [74.8]) from the sixth threshold value unit (72) is assigned at least one second pointer ([76]) to a filter coefficient table (82) associated with the filter unit (94).

3. Method according to Claim 2, **characterized in that**
(g.1) the first pointer ([46]) and the second pointer ([76]) are supplied to maximum value formation in at least one third comparator unit (80), and
(g.2) the at least one filter coefficient ([84.0]; [84.1]; [84.2]; [84.3]; [84.4]; [84.5]; [84.6]; [84.7]) from the filter coefficient table (82), to which filter coefficient the output signal (M₃) from the third comparator unit (80) points, is transmitted to the filter unit (94).

4. Method according to at least one of Claims 1 to 3, **characterized in that**
- the first processing path (204) operates at a first sampling rate in the order of magnitude of 0 hertz to approximately 950 hertz, so that the treble reproduction can be attenuated for periods of up to approximately thirty seconds using the first processing path (204), and/or
- the second processing path (507) operates at a second sampling rate in the order of magnitude of approximately 9.5 kilohertz, so that the treble reproduction can be attenuated for periods of significantly shorter than thirty seconds using the second processing path (507).

5. Method according at least one of Claims 1 to 4, **characterized in that** the control of the influencing, particularly the reduction, of the treble reproduction of the audio signal (90, 92) is coupled to control, particularly to reduction, of the separation of the L[eft] channel (90) and the R[ight] channel (92) of the audio signal (90, 92) such that the same components, particularly the same detectors and the same threshold decisions, are used at least for the first processing path (204) and at least for the slower portion of the control of the separation of the L[eft] channel (90) and the R[ight] channel (92) of the audio signal (90, 92).

6. Circuit arrangement (100) for influencing, particularly reducing, the treble reproduction of an audio signal (90, 92) to be reproduced which is obtained from a received signal, wherein the reception field strength (12) and the reception quality of the received signal can be evaluated and this can be taken as a basis for controlling the transfer function of at least one filter unit (94) to which the audio signal (90, 92) can be applied, **characterized**
- **in that** at least two reception noise detectors (10a, 10b) are connected upstream, the output signals from which, like the reception field strength (12), can be processed
-- in at least one first processing path (204) operating at a first, in particular variable sampling rate and
-- in at least one second processing path (507) operating at a second sampling rate,
and
- **in that** the first sampling rate is lower than the second sampling rate such
- that the treble reproduction can be attenuated for longer periods using the first processing path (204) than using the second processing path (507).

7. Circuit arrangement according to Claim 6, **characterized**
- **in that** the first processing path (204) has
-- at least one first weighting unit (20a), in which the output signal from the first reception noise detector (10a) can be weighted,
-- at least one first threshold value unit (22a), in which the output signal from the first weighting unit (20a) can be supplied to at least one threshold value decision,
-- at least one second weighting unit (20b), in which the output signal from the second reception noise detector (10b) can be weighted,
-- at least one second threshold value unit (22b), in which the output signal from the second weighting unit (20b) can be supplied to at least one threshold value decision,
-- at least one first logic unit (24), in which the output signal from the first threshold value unit (22a) and the output signal from the second threshold value unit (22b) can be supplied to logic ORing,
-- at least one first ramp unit (26), in which the output signal from the first logic unit (24) can be supplied to an asymmetric ramp having a short rise time and a long fall time,
-- at least one first reset/hold unit (28), to which the output signal from the first ramp unit (26) can be supplied,
-- at least one first characteristic curve unit (30), in which the signal from the reception field strength (12) can be supplied to a first characteristic curve such
--- that at low reception field strength (12) a high output signal from the first characteristic curve unit (30) can be produced and
--- that at high reception field strength (12) a low or exceedingly low output signal from the first characteristic curve unit (30) can be produced,
-- at least one second reset/hold unit (32), to which the output signal from the first characteristic curve unit (30) can be supplied,
-- at least one first comparator unit (40), in which the output signal from the first reset/hold unit (28) and the output signal from the second reset/hold unit (32) can be supplied to maximum value formation,
-- at least one third threshold value unit (42), in which the output signal (M₁) from the first comparator unit (40) can be supplied to at least one threshold value decision in order to form at least one new first threshold value ([44.0]; [44.1]; [44.2]; [44.3]; [44.4]; [44.5]; [44.6]; [44.7]; [44.8]) which can be assigned at least one first pointer ([46]) to a filter coefficient table (82) associated with the filter unit (94),
and/or
- **in that** the second processing path (507) has
-- at least one third weighting unit (50a), in which the output signal from the first reception noise detector (10a) can be weighted,
-- at least one fourth threshold value unit (52a), in which the output signal from the third weighting unit (50a) can be supplied to a threshold value decision,
-- at least one fourth weighting unit (50b), in which the output signal from the second reception noise detector (10b) can be weighted,
-- at least one fifth threshold value unit (52b), in which the output signal from the fourth weighting unit (50b) can be supplied to a threshold value decision,
-- at least one second logic unit (54), in which the output signal from the fourth threshold value unit (52a) and the output signal from the fifth threshold value unit (52b) can be supplied to logic ORing,
-- at least one second ramp unit (56), in which the output signal from the second logic unit (54) can be supplied to an asymmetrical ramp having a short rise time and a long fall time,
-- at least one scaling unit (58), to which the output signal from the second ramp unit (56) can be supplied,
-- at least one second characteristic curve unit (60), in which the signal from the reception field strength (12) can be supplied to a second characteristic curve such
--- that at low reception field strength (12) a high output signal from the second characteristic curve unit (60) can be produced and
--- that at high reception field strength (12) a low or exceedingly low output signal from the second characteristic curve unit (60) can be produced,
-- at least one second comparator unit (70), in which the output signal from the scaling unit (58) and the output signal from the second characteristic curve unit (60) can be supplied to maximum value formation,
-- at least one sixth threshold value unit (72), in which the output signal (M₂) from the second comparator unit (70) can be supplied to at least one threshold value decision in order to form at least one new second threshold value ([74.0]; [74.1]; [74.2]; [74.3]; [74.4]; [74.5]; [74.6]; [74.7]; [74.8]) which can be assigned at least one second pointer ([76]) to a filter coefficient table (82) associated with the filter unit (94).

8. Circuit arrangement according to Claim 7, **characterized by** at least one third comparator unit (80) in which the first pointer ([46]) and the second pointer ([76]) can be supplied to maximum value formation, wherein the at least one filter coefficient ([84.0]; [84.1]; [84.2]; [84.3]; [84.4]; [84.5]; [84.6]; [84.7]) from the filter coefficient table (82), to which filter coefficient the output signal (M₁₃) from the third comparator unit (80) points, can be transmitted to the filter unit (94).

9. Circuit arrangement according to at least one of Claims 6 to 8, **characterized in that**
- the first processing path (204) has a first sampling rate in the order of magnitude of 0 hertz to approximately 950 hertz, so that the treble reproduction can be attenuated for periods of up to approximately thirty seconds using the first processing path (204), and/or
- the second processing path (507) has a second sampling rate in the order of magnitude of approximately 9.5 kilohertz, so that the treble reproduction can be attenuated for periods of significantly shorter than thirty seconds using the second processing path (507).

10. Use of a method according to at least one of Claims 1 to 5 and/or of at least one circuit arrangement (100) according to at least one of Claims 6 to 9 for influencing, particularly for reducing, the treble reproduction of an audio signal (90, 92) to be reproduced which is obtained from a received broadcast radio signal in at least one broadcast radio receiver, particularly in at least one broadcast radio receiver with digital intermediate frequency processing.

## Revendications

1. Procédé pour influencer, notamment pour réduire, la reproduction des aiguës d'un signal audio (90, 92) à reproduire, obtenu à partir d'un signal reçu, l'intensité du champ de réception (12) ainsi que la qualité de réception du signal reçu étant évaluées et la fonction de transfert d'au moins une unité de filtrage (94) exposée au signal audio (90, 92) étant commandée en fonction de celles-ci,
**caractérisé en ce**
- **que** le traitement des signaux de sortie d'au moins deux détecteurs de perturbations de réception (10a, 10b) ainsi que le traitement de l'intensité du champ de réception (12) s'effectuant à chaque fois
-- dans au moins une première branche de traitement (204) fonctionnant à une première fréquence d'échantillonnage, notamment variable et
-- dans au moins une deuxième branche de traitement (507) fonctionnant à une deuxième fréquence d'échantillonnage et
- **que** la première fréquence d'échantillonnage est réglée inférieure à la deuxième fréquence d'échantillonnage de telle sorte
- **que** la reproduction des aiguës peut être atténuée au moyen de la première branche de traitement (204) pendant des périodes plus longues qu'au moyen de la deuxième branche de traitement (507).

2. Procédé selon la revendication 1, **caractérisé en ce**
- **que** dans la première branche de traitement (204)
(a.1) le signal de sortie du premier détecteur de perturbations de réception (10a) est pondéré dans au moins une première unité de pondération (20a),
(a.2) le signal de sortie de la première unité de pondération (20a) est acheminé à au moins un décideur de valeur de seuil dans au moins une première unité de valeur de seuil (22a),
(a.3) le signal de sortie du deuxième détecteur de perturbations de réception (10b) est pondéré dans au moins une deuxième unité de pondération (20b),
(a.4) le signal de sortie de la deuxième unité de pondération (20b) est acheminé à au moins un décideur de valeur de seuil dans au moins une deuxième unité de valeur de seuil (22b),
(a.5) le signal de sortie de la première unité de valeur de seuil (22a) et le signal de sortie de la deuxième unité de valeur de seuil (22b) sont soumis à une combinaison logique OU dans au moins une première unité logique (24),
(a.6) le signal de sortie de la première unité logique (24) est acheminé dans au moins une première unité de rampe (26) à une rampe asymétrique présentant un temps de montée court et un temps de descente long,
(a.7) le signal de sortie de la première unité de rampe (26) est acheminé à au moins une première unité de réinitialisation/maintien (28),
(b.1) le signal de l'intensité du champ de réception (12) est acheminé à une première courbe caractéristique dans au moins une première unité à courbe caractéristique (30) de telle sorte
(b.1.1) que, lorsque l'intensité du champ de réception (12) est faible, un signal de sortie élevé de la première unité à courbe caractéristique (30) est généré et
(b.1.2) que, lorsque l'intensité du champ de réception (12) est élevée, un signal de sortie faible ou s'évanouissant de la première unité à courbe caractéristique (30) est généré,
(b.2) le signal de sortie de la première unité à courbe caractéristique (30) est acheminé à au moins une deuxième unité de réinitialisation/maintien (32),
(c.1) le signal de sortie de la première unité de réinitialisation/maintien (28) et le signal de sortie de la deuxième unité de réinitialisation/maintien (32) sont acheminés à un calcul de la valeur maximale dans au moins une première unité de comparaison (40),
(c.2) le signal de sortie (M₁) de la première unité de comparaison (40) est acheminé à au moins un décideur de valeur de seuil dans au moins une troisième unité de valeur de seuil (42), de manière à former au moins une nouvelle première valeur de seuil ([44.0] ; [44.1] ; [44.2] ; [44.3] ; [44.4] ; [44.5] ; [44.6] ; [44.7] ; [44.8]) et
(c.3) au moins un premier pointeur ([46]) sur un tableau de coefficients de filtrage (82) associé à l'unité de filtrage (94) est associé à la nouvelle première valeur de seuil ([44.0] ; [44.1] ; [44.2] ; [44.3] ; [44.4] ; [44.5] ; [44.6] ; [44.7] [44.8]) de la troisième unité de valeur de seuil (42) et/ou
- **que** dans la deuxième branche de traitement (507)
(d.1) le signal de sortie du premier détecteur de perturbations de réception (10a) est pondéré dans au moins une troisième unité de pondération (50a),
(d.2) le signal de sortie de la troisième unité de pondération (50a) est acheminé à au moins un décideur de valeur de seuil dans au moins une quatrième unité de valeur de seuil (52a),
(d.3) le signal de sortie du deuxième détecteur de perturbations de réception (10b) est pondéré dans au moins une quatrième unité de pondération (50b),
(d.4) le signal de sortie de la quatrième unité de pondération (50b) est acheminé à au moins un décideur de valeur de seuil dans au moins une cinquième unité de valeur de seuil (52b),
(d.5) le signal de sortie de la quatrième unité de valeur de seuil (52a) et le signal de sortie de la cinquième unité de valeur de seuil (52b) sont soumis à une combinaison logique OU dans au moins une deuxième unité logique (54),
(d.6) le signal de sortie de la deuxième unité logique (54) est acheminé dans au moins une deuxième unité de rampe (56) à une rampe asymétrique présentant un temps de montée court et un temps de descente long,
(d.7) le signal de sortie de la deuxième unité de rampe (56) est acheminé à une unité de mise à l'échelle (58).
(e.1) le signal de l'intensité du champ de réception (12) est acheminé à une deuxième courbe caractéristique dans au moins une deuxième unité à courbe caractéristique (60) de telle sorte
(e.1.1) que, lorsque l'intensité du champ de réception (12) est faible, un signal de sortie élevé de la deuxième unité à courbe caractéristique (60) est généré et
(e.1.2) que, lorsque l'intensité du champ de réception (12) est élevée, un signal de sortie faible ou s'évanouissant de la deuxième unité à courbe caractéristique (60) est généré,
(f.1) le signal de sortie de l'unité de mise à l'échelle (58) et le signal de sortie de la deuxième unité à courbe caractéristique (60) sont acheminés à un calcul de la valeur maximale dans au moins une deuxième unité de comparaison (70),
(f.2) le signal de sortie (M₂) de la deuxième unité de comparaison (70) est acheminé à au moins un décideur de valeur de seuil dans au moins une sixième unité de valeur de seuil (72), de manière à former au moins une nouvelle deuxième valeur de seuil ([74.0] ; [74.1] ; [74.2] ; [74.3] ; [74.4] ; [74.5] ; [74.6] ; [74.7] ; [74.8]) et
(f.3) au moins un deuxième pointeur ([76]) sur un tableau de coefficients de filtrage (82) associé à l'unité de filtrage (94) est associé à la nouvelle deuxième valeur de seuil ([74.0] ; [74.1] ; [74.2] ; [74.3] ; [74.4] ; [74.5] ; [74.6] ; [74.7] ; [74.8]) de la sixième unité de valeur de seuil (72).

3. Procédé selon la revendication 2, **caractérisé en ce que**
(g.1) le premier pointeur ([46]) et le deuxième pointeur ([76]) sont acheminés à un calcul de la valeur maximale dans au moins une troisième unité de comparaison (80) et
(g.2) l'au moins un coefficient de filtrage ([84.0] ; [84.1] ; [84.2] ; [84.3] ; [84.4] ; [84.5] ; [84.6] ; [84.7]) du tableau de coefficients de filtrage (82) vers lequel renvoie le signal de sortie (M₃) de la troisième unité de comparaison (80) est transmis à l'unité de filtrage (94).

4. Procédé selon au moins l'une des revendications 1 à 3, **caractérisé en ce que**
- la première branche de traitement (204) fonctionne à une première fréquence d'échantillonnage de l'ordre de 0 Hertz à environ 950 Hertz, de sorte que la reproduction des aiguës peut être atténuée au moyen de la première branche de traitement (204) pendant des périodes pouvant aller jusqu'à environ 30 secondes et/ou
- la deuxième branche de traitement (507) fonctionne à une deuxième fréquence d'échantillonnage de l'ordre d'environ 9,5 kilohertz, de sorte que la reproduction des aiguës peut être atténuée au moyen de la deuxième branche de traitement (507) pendant des périodes considérablement plus courtes que 30 secondes.

5. Procédé selon au moins l'une des revendications 1 à 4, **caractérisé en ce que** la commande de l'influence, notamment de la réduction, de la reproduction des aiguës du signal audio (90, 92) est couplée à une commande, notamment à une réduction, de la séparation de la voie de gauche (90) et de la voie de droite (92) du signal audio (90, 92) de telle sorte que les mêmes composants, notamment les mêmes détecteurs et les mêmes décideurs de valeur de seuil, sont utilisés au moins pour la première branche de traitement (204) et au moins pour la partie la plus lente de la commande de la séparation de la voie de gauche (90) et de la voie de droite (92) du signal audio (90, 92).

6. Arrangement de circuit (100) pour influencer, notamment pour réduire, la reproduction des aiguës d'un signal audio (90, 92) à reproduire, obtenu à partir d'un signal reçu, l'intensité du champ de réception (12) ainsi que la qualité de réception du signal reçu pouvant être évaluées et la fonction de transfert d'au moins une unité de filtrage (94) exposée au signal audio (90, 92) pouvant être commandée en fonction de celles-ci,
**caractérisé en ce**
- **qu'**au moins deux détecteurs de perturbations de réception (10a, 10b) sont branchés en amont, dont les signaux de sortie ainsi que l'intensité du champ de réception (12) peuvent être traités
-- dans au moins une première branche de traitement (204) fonctionnant à une première fréquence d'échantillonnage, notamment variable et
-- dans au moins une deuxième branche de traitement (507) fonctionnant à une deuxième fréquence d'échantillonnage et
- **que** la première fréquence d'échantillonnage est réglée inférieure à la deuxième fréquence d'échantillonnage de telle sorte
- **que** la reproduction des aiguës peut être atténuée au moyen de la première branche de traitement (204) pendant des périodes plus longues qu'au moyen de la deuxième branche de traitement (507).

7. Arrangement de circuit selon la revendication 6, **caractérisé en ce**
- **que** la première branche de traitement (204) présente
-- au moins une première unité de pondération (20a) dans laquelle le signal de sortie du premier détecteur de perturbations de réception (10a) peut être pondéré,
-- au moins une première unité de valeur de seuil (22a) dans laquelle le signal de sortie de la première unité de pondération (20a) peut être acheminé à au moins un décideur de valeur de seuil,
-- au moins une deuxième unité de pondération (20b) dans laquelle le signal de sortie du deuxième détecteur de perturbations de réception (10b) peut être pondéré,
-- au moins une deuxième unité de valeur de seuil (22b) dans laquelle le signal de sortie de la deuxième unité de pondération (20b) peut être acheminé à au moins un décideur de valeur de seuil,
-- au moins une première unité logique (24) dans laquelle le signal de sortie de la première unité de valeur de seuil (22a) et le signal de sortie de la deuxième unité de valeur de seuil (22b) peuvent être acheminés à une combinaison logique OU,
-- au moins une première unité de rampe (26) dans laquelle le signal de sortie de la première unité logique (24) peut être acheminé à une rampe asymétrique présentant un temps de montée court et un temps de descente long,
-- au moins une première unité de réinitialisation/maintien (28) à laquelle peut être acheminé le signal de sortie de la première unité de rampe (26),
-- au moins une première unité à courbe caractéristique (30) dans laquelle le signal de l'intensité du champ de réception (12) peut être acheminé à une première courbe caractéristique de telle sorte
--- que, lorsque l'intensité du champ de réception (12) est faible, un signal de sortie élevé de la première unité à courbe caractéristique (30) peut être généré et
--- que, lorsque l'intensité du champ de réception (12) est élevée, un signal de sortie faible ou s'évanouissant de la première unité à courbe caractéristique (30) peut être généré,
-- au moins une deuxième unité de réinitialisation/maintien (32) à laquelle peut être acheminé le signal de sortie de la première unité à courbe caractéristique (30),
-- au moins une première unité de comparaison (40) dans laquelle le signal de sortie de la première unité de réinitialisation/maintien (28) et le signal de sortie de la deuxième unité de réinitialisation/maintien (32) peuvent être acheminés à un calcul de la valeur maximale,
-- au moins une troisième unité de valeur de seuil (42) dans laquelle le signal de sortie (M₁) de la première unité de comparaison (40) peut être acheminé à au moins un décideur de valeur de seuil, de manière à former au moins une nouvelle première valeur de seuil ([44.0] ; [44.1] ; [44.2] ; [44.3] ; [44.4] ; [44.5] ; [44.6] ; [44.7] ; [44.8]) à laquelle peut être associé au moins un premier pointeur ([46]) sur un tableau de coefficients de filtrage (82) associé à l'unité de filtrage (94),
et/ou
- **que** la deuxième branche de traitement (507) présente
-- au moins une troisième unité de pondération (50a) dans laquelle le signal de sortie du premier détecteur de perturbations de réception (10a) peut être pondéré,
-- au moins une quatrième unité de valeur de seuil (52a) dans laquelle le signal de sortie de la troisième unité de pondération (50a) peut être acheminé à un décideur de valeur de seuil,
-- au moins une quatrième unité de pondération (50b) dans laquelle le signal de sortie du deuxième détecteur de perturbations de réception (10b) peut être pondéré,
-- au moins une cinquième unité de valeur de seuil (52b) dans lequel le signal de sortie de la quatrième unité de pondération (50b) peut être acheminé à un décideur de valeur de seuil,
-- au moins une deuxième unité logique (54) dans laquelle le signal de sortie de la quatrième unité de valeur de seuil (52a) et le signal de sortie de la cinquième unité de valeur de seuil (52b) peuvent être acheminés à une combinaison logique OU,
-- au moins une deuxième unité de rampe (56) dans laquelle le signal de sortie de la deuxième unité logique (54) peut être acheminé à une rampe asymétrique présentant un temps de montée court et un temps de descente long,
-- au moins une unité de mise à l'échelle (58) à laquelle peut être acheminé le signal de sortie de la deuxième unité de rampe (56),
-- au moins une deuxième unité à courbe caractéristique (60) dans laquelle le signal de l'intensité du champ de réception (12) peut être acheminé à une deuxième courbe caractéristique de telle sorte
--- que, lorsque l'intensité du champ de réception (12) est faible, un signal de sortie élevé de la deuxième unité à courbe caractéristique (60) peut être généré et
--- que, lorsque l'intensité du champ de réception (12) est élevée, un signal de sortie faible ou s'évanouissant de la deuxième unité à courbe caractéristique (60) peut être généré,
-- au moins une deuxième unité de comparaison (70) dans laquelle le signal de sortie de l'unité de mise à l'échelle (58) et le signal de sortie de la deuxième unité à courbe caractéristique (60) peuvent être acheminés à un calcul de la valeur maximale,
-- au moins une sixième unité de valeur de seuil (72) dans laquelle le signal de sortie (M₂) de la deuxième unité de comparaison (70) peut être acheminé à au moins un décideur de valeur de seuil, de manière à former au moins une nouvelle deuxième valeur de seuil ([74.0] ; [74.1] ; [74.2] ; [74.3] ; [74.4] ; [74.5] ; [74.6] ; [74.7] ; [74.8]) à laquelle peut être associé au moins un deuxième pointeur ([76]) sur un tableau de coefficients de filtrage (82) associé à l'unité de filtrage (94).

8. Arrangement de circuit selon la revendication 7, **caractérisé par** au moins une troisième unité de comparaison (80) dans laquelle le premier pointeur ([46]) et le deuxième pointeur ([76]) peuvent être acheminés à un calcul de la valeur maximale, l'au moins un coefficient de filtrage ([84.0] ; [84.1] ; [84.2] ; [84.3] ; [84.4] ; [84.5] ; [84.6] ; [84.7]) du tableau de coefficients de filtrage (82) vers lequel renvoie le signal de sortie (M₁₃) de la troisième unité de comparaison (80) pouvant être transmis à l'unité de filtrage (94).

9. Arrangement de circuit selon au moins l'une des revendications 6 à 8, **caractérisé en ce que**
- la première branche de traitement (204) présente une première fréquence d'échantillonnage de l'ordre de 0 Hertz à environ 950 Hertz, de sorte que la reproduction des aiguës peut être atténuée au moyen de la première branche de traitement (204) pendant des périodes pouvant aller jusqu'à environ 30 secondes et/ou
- la deuxième branche de traitement (507) présente une deuxième fréquence d'échantillonnage de l'ordre d'environ 9,5 kilohertz, de sorte que la reproduction des aiguës peut être atténuée au moyen de la deuxième branche de traitement (507) pendant des périodes considérablement plus courtes que 30 secondes.

10. Procédé selon au moins l'une des revendications 1 à 5 et/ou au moins un arrangement de circuit (100) selon au moins l'une des revendications 6 à 9 pour influencer, notamment pour réduire, la reproduction des aiguës d'un signal audio (90, 92) à reproduire, obtenu à partir d'un signal de radiodiffusion reçu, dans au moins un récepteur de radiodiffusion, notamment dans au moins un récepteur de radiodiffusion avec traitement numérique de la fréquence intermédiaire.
